# EUROPEAN PATENT APPLICATION

(11) **EP 3 799 134 A1**
(43) Date of publication of application: **31.03.2021**
(21) Application number: 19382837.3
(22) Date of filing: 30.09.2019
(51) Int. Cl.: H01L 31/0468, H01L 31/0465, H01L 31/0224, H01L 31/0749

(54) **SOLAR MODULE**

(71) Applicant: FUNDACIÓ INSTITUT DE RECERCA EN ENERGIA DE CATALUNYA, 08930 Barcelona (ES); Universitat de Barcelona, 08028 Barcelona (ES)
(72) Inventor: Jehl, Zacharie, 08911 BADALONA (ES); Placidi, Marcel, 08173 SANT CUGAT (ES); Giraldo Muñoz, Sergio, 08921 SANTA COLOMA DE GRAMENET (ES); Tiwari, Kunal, 08032 BARCELONA (ES); Becerril, Ignacio, 08020 BARCELONA (ES); López García, Alejandro, 08009 BARCELONA (ES); Pérez Rodríguez, Alejandro, 08029 BARCELONA (ES); Blázquez Martínez, Alfredo, 41003 SEVILLA (ES); Sánchez González, Yudania, 08031 BARCELONA (ES); Saucedo Silva, Edgardo, 08029 BARCELONA (ES)
(74) Representative: ZBM Patents - Zea, Barlocci & Markvardsen

(57) **Abstract**

The present disclosure presents a solar module and a method for fabricating a solar module. A solar module according to the present disclosure comprises a layered structure with a rear TCM layer contacting a substrate and a metallic finger.

## Description

### Field of the invention and Background

This specification relates to a solar module and a method for fabricating a solar module.

Solar modules may be fabricated using different types of technology. Thin-film solar technology may rely on a substrate-based approach, that is, fabricating a solar module starting from a substrate, which may be soda lime glass, and continuing forming a complete stack built from a back contact to a front contact.

Superstrate technologies are a second type of technology, in which the solar modules may be built from a front contact to a back contact, as in Cadmium telluride, CdTe, modules.

A solar module may comprise a layer called "absorber", in which light is absorbed, generating 2 types of photocarriers, holes and electrons. The photocarriers are collected at the front and the back contacts of the solar cell. Depending on the type of solar cell, p-n or n-p, a certain type of photocarrier is collected on the front contact or at the back contacts of the solar module.

There exist different designs of contacts in solar modules. A solar module may be composed of different solar cells connected in series or in parallel. A solar cell is an individual entity producing a voltage when illuminated. A solar module may also be referred to as solar panel. Solar modules may be stripe shaped, and a solar cell may therefore be referred to as solar stripe. A planar design may rely on stacking different layers building the solar cell in a 2D plane. Each "n" layer is in direct contact with the "n+1" layer. A back contact of the solar cell may be a few µm metallic layer deposited on a glass substrate. A front side or front contact of the solar cell may be transparent in order to let light coming through the absorber; transparent conductive oxides, TCOs, may be used to collect the photogenerated charge photocarriers, holes or electrons. A TCO may exhibit a high transparency but a relatively poor conductivity, wherein the conductivity may be understood as an intrinsic property of a material which may be defined as the inverse of the resistivity.

Since in TCO materials the diffusion length of electric carriers may result in poor conduction, after a few cm, or even mm, the carriers may lose their energy that defines the electric current and the electric current therefore stops circulating; such energy may be, for example, potential energy, depending on the position in the band, and/or kinetic energy, related to the carrier transport, or blend between potential energy and kinetic energy. This is the reason why photocarriers may be collected on few cm away from the TCO, for example, less than 1cm from the front TCO contact before experiencing a series resistance effect. Hence, a metallic grid may be deposited on the front TCO contact to improve the photocarrier collection. Some of the problems of this type of planar structures with metallic grids may be that potential metal scarcity may appear, for example when using silver metallic grids and that the metallic grid fabrication step adds a cost to the fabrication process, since in a planar design, the final TCO may be coated by a metallic grid, usually fabricated by thermal evaporation. Such process may require a separate machine and may function under moderate vacuum. The pressure used for metallic evaporation may range from 10⁻⁵ Torr to 10⁻⁶ Torr, though some process may use lower or higher pressures in specific cases. The whole process, while simple, is costly and often difficult to adapt to large panel areas.

Besides, since the back contact is made of metal, it is not transparent, and this type of solar cells can only generate power from light coming at the front side. Planar design being simple to fabricate, it is typically used at a laboratory scale for thin film solar cells or modules.

There also exist planar designs in which a bifacial design is used to provide thin film solar cells with transparent back contacts, for example TCO back contacts, at a small scale. Such designs present an electrical resistivity of the TCO contacts acceptable at laboratory scale. Such TCO contacts resistivity represents however a problem for large area bifacial solar cells, since the back TCO resistance becomes dominant and significantly reduces the generated current and therefore the power conversion efficiency of the solar cells.

A monolithic design may alleviate the aforementioned issues of front metallic grids by eliminating such metallic grid and benefiting from the high conductivity of the metallic back contact to collect the generated photocarriers. To avoid short-circuiting the solar panel, a laser or mechanical scribing process is used to delimitate stripes/cells of the solar module. In this design, the metallic contact of a stripe/cell "n" is in contact with the transparent front contact of a stripe or cell "n-1" and the transparent front contact of the stripe/cell "n" is in contact with the metallic back contact of a stripe or cell "n+1". Such configuration allows a set of stripe or cells to be connected in series. The stripes or cells may have a width of a few mm, defined according to the collection length at the front TCO contact, and no front metallic grid is needed. The back contact being made of metal, it is not transparent, and this type of solar panel can only generate power from light coming at the front side. The monolithic design is typically used in the industry of thin film solar panels.

It is an object of the present invention to provide solar modules which maintain or improve the power efficiency at large or industrial scale, and which can be fabricated without significantly altering current production processes.

### Summary

The present disclosure specifies a solar module. Solar cells composing a solar module may produce electricity through a natural reaction called the photovoltaic effect.

A premise of the photovoltaic effect is the creation of a voltage in a material upon exposure to light. This effect may occur in materials like semiconductors in which the distribution of the electronic energy levels creates two differentiated energy bands, the valence band and the conduction band. If an incident light provides an energy above the energy difference between both bands, commonly known as bandgap, an electron may be promoted from the valence to the conduction band leaving a hole at the valence band and, thus, generating a so-called electron-hole pair. The unbalance between the electron and hole populations may result in an internal voltage in the material. If the electrons and the holes are selectively collected, an electromotive force and an electric current may be induced into an external circuit resulting in the production of energy. Carrier or photocarrier selectivity may be achieved joining together a semiconductor with an excess of holes, a p-semiconductor, and a semiconductor with an excess of electrons, an n-semiconductor, in a so-called p-n junction. The potential barrier between the p and the n semiconductor allows only one type of carrier to go through the interface in a given direction effectively separating them." For example, an electrical load may create an external circuit by connecting each of its electrical poles to each semiconductor; the semiconductors may force the current out of the cell and the electrical load may capture the energy. The electrons then may continue their path and they may re-enter the cell and connect with the positive layer. Such path may complete the circuit and may allow the process to continue.

A solar module according to the present specification may comprise a substrate and a layered structure contacting the substrate. The substrate may comprise a material suitable for accepting a deposition of a conductive material, for example a substrate may comprise a glass substrate, or flexible transparent plastics. The substrate may be a flat glass panel. Some developments provide for flexible substrates, sometimes made of transparent plastics, in which case, a so called "roll to roll" process may be used for its fabrication. A process for fabricating such roll to roll flexible substrates may comprise starting from a roll of flexible plastic which may be rolled on itself, going through a full solar panel fabrication process, and ending up with a roll of plastic coated with solar materials.

The layered structure may comprise a rear transparent conductive material, TCM, layer, contacting the substrate, an absorber layer arranged in contact with the rear TCM layer and a front transparent conducting oxide, TCO, layer in contact with the absorber layer in such a way that the absorber layer remains between the front TCO layer and the rear TCM layer. The layered structure allows building the so called "top" or negative conductor or front TCO layer, and the "bottom" or positive conductor on the substrate.

The rear TCM layer may also be called transparent conducting film, TCF, and may be a thin film of optically transparent and electrically conductive material. The TCM layers may be a component in a number of electronic devices including liquid-crystal displays, OLEDs, touchscreens and photovoltaics. Some TCM may be used for photovoltaic applications, being fabricated from both inorganic and organic materials. Inorganic films may be made up of a layer of transparent conducting oxide, TCO, indium tin oxide, ITO, fluorine doped tin oxide, FTO, or doped zinc oxide. Organic films may be developed using carbon nanotube networks and graphene, which may be fabricated to be highly transparent to infrared light, along with networks of polymers. TCM may comprise Transparent Conductive Oxide, which may be usually used for thin film solar cells or solar modules. A bi-layer combination of a TCO with a thin, i.e. less than 50nm, interfacial layer, for example: MoSe₂, may also be referred to as a TCM.

Transparent conducting films may be used as electrodes for providing low resistance electrical contacts allowing light to pass through. Transparent materials comprise bandgaps whose energy value is greater than those of visible light. Bandgaps are also called energy gaps, which may be understood as an energy range in a solid where no electron states exist. Photons with energies below a bandgap value are not absorbed by the materials and visible light passes through. Solar cells applications may require a range of transparency beyond visible light to make efficient use of the full solar spectrum. Rear transparent contacts in solar cells or modules may be used at a laboratory scale, with Transparent Conductive Materials, TCMs, and Transparent Conducting Oxides, TCOs, for which the conductivity is at least two orders of magnitudes lower than that of the metals used as back contacts in standard thin film solar modules. In the laboratory, a small size solar cells or solar modules may be used for proof of concept of transparent rear or back contacts; such low conductivity does not significantly alter the performances of tested solar cells or solar modules. Commercial or industrial solar modules may have a size of 120cmx60cm, or 1m² and the series resistance from the TCM back contact may become detrimental for the performance of a photovoltaic module.

The absorber layer allows the current to flow through. The chemical bonds of the material are essential for the current to flow, and silicon may be used for building the absorber layer although other materials, such as copper indium gallium selenide, CuInGaSe₂, may also be used. The absorber layer may have different chemical electric charges and subsequently both drive and direct the current of electrons.

The front layer may comprise a transparent conductive oxide, TCO, and allows letting the light through, so that photons can be absorbed by the absorber layer and electron-hole pairs can be created.

The layered structure may comprise at least an electrically insulating zone configured for redirecting an electrical current flowing through a layer, such that, in operation, electric current stops flowing at a same layer at the electrically insulating zone; in other words, each insulating zone avoids, at each layer, current from continuing flowing through a same layer. Such configuration obliges a current to find an alternative electrical pathway through other layers. For example, if a positive pole is placed at a side of a solar module and a negative pole is placed at an opposite side of a solar module, a current may be generated from the positive contact towards the negative contact which may flow through the rear TCM layer until an insulating zone in the rear TCM layer, where the electrical current may find an alternative pathway through the absorber layer and through the front TCO layer. Flowing through the TCO layer, the electrical current may find an insulting zone in the front TCO layer, where the electrical current may find an alternative pathway through the absorber layer and through the rear TCM layer. The insulating or electrical transparent zones allow avoiding short circuits and disconnecting some layers from others. Such insulating zones or transparent zones allow providing a monolithic design.

The layered structure may further comprise at least a connection zone in such a way that, when serially connecting a set of solar cells, wherein a solar cell is a structure delimited by two electrically insulating zones, the front TCO layer of a first solar cell contacts the rear TCM layer of a second solar cell and the front TCO layer of the second solar cell contacts the rear TCM layer of a third solar cell.

The rear TCM layer may further contact at least a part of at least one metallic finger, wherein the at least one metallic finger is configured to provide conduction channels for the electrical current to flow across the rear TCM layer of the solar module. The metallic finger is configured to avoid contacting all the layers of the stack such that the solar cells and module are not short-circuited; for such reason, a metallic finger of the present disclosure is not inserted in such a way that it may contact several layers of the layer structure. The metallic finger according to the present disclosure improves the conduction properties of the rear TCM layer of a solar cells and a solar module. The rear TCM layer may further contact a metallic finger in such a way that the substrate contacts at least a second part of the metallic finger. A second part of the metallic finger may be different from "a part of the metallic finger". A second part of the metallic finger may be part or coincide at least in part with "a part of the metallic finger". A metallic finger may extend over a part of the solar module or may cover a whole dimension of the solar module, perpendicularly to a direction in which an electrical current may flow, or parallel to a direction in which an electrical current may flow across a layer, which may be more efficient.

The rear TCM layer may further contact two or more metallic fingers, or metallic stripes.

The solar module according to the present invention may comprise a set of metallic fingers forming a metallic grid, wherein the metallic fingers may be positioned substantially parallel to an interfacing plane between the substrate layer and the rear TCM layer. In the context of the present specification a metallic grid may be understood as a set of parallel fingers not touching each other, or as a set of fingers not necessarily parallel to each other and crossing and/or touching each other within the same solar cell. A set of fingers do not touch between different solar cells as it may result in a short circuit. The set of metallic fingers or grid may extend over a part of a solar cell or may cover a whole dimension of a solar cell, parallel or perpendicular to a direction in which an electrical current may flow across a layer, or in any other direction.

A metallic grid design and specifically the orientation of the fingers may depend on features or properties that the solar module may present. In an example, a design of a metallic grid may comprise a mixture of perpendicular and parallel fingers forming a squared shape mesh of metallic fingers, or other shapes, for example a rhomboid shaped mesh. The number of fingers per solar cell may depend on properties desired, dimensions of the fingers, and their orientation with respect to the flow of electrical current or with respect to the solar stripes. For fingers visible with the naked eye, for example, with a lateral width of about 300µm for example, a spacing between them will be about 3mm. In the case of fingers perpendicular to the current flow, there may be 3 fingers per solar stripe or solar cell, which results in about 600 fingers for a complete module of 200 stripes. In the case of fingers parallel to the current flow, the fingers may be shorter, and their length may coincide with the width of a solar stripe, but their number may be higher or much higher per solar stripe, for example about 200-300 per solar stripe. For a complete module of 200 stripes, there might be about 40000-60000 "short" fingers, wherein "short" may be understood as few mm, for example between 5 and 10 mm, since they would only cover the width of a stripe.

As the it may be apparent from the present disclosure, these are only examples, and density of fingers may also be described instead of a number of fingers. In some examples of "visible fingers", considering a finger width of 300µm spaced between each other by a distance of 2.7mm for example, a metallic coverage density may amount 10%.

For "invisible" fingers, such values may be divided by 10 wherein 30µm wide fingers spaced by 270µm, may amount for a 10% of metallic coverage density, and the total number of fingers in the module may be 10 times more that in the previous example of visible fingers.

A solar module according to the present disclosure, comprising a metallic finger in or at the rear TCM layer or comprising a metallic grid in or at the rear TCM layer presents, therefore, conduction channels for the electric current to flow across the transparent rear contact, rear TCM layer, of a bifacial solar module. Such conduction channels in the form of a metallic patterning or a metallic collection gridmay be comprised at different levels, for example at the rear TCM layer-absorber interface, for example inside the TCM, or for example at the substrate-rear TCM layer interface.

The substrate-rear TCM layer interface comprising a metallic finger or grid, may be a more efficient design from a fabrication point of view than comprising a metallic finger or grid at the other two levels, and it avoids unwanted material interfaces between the metallic grid and the absorber. Such unwanted material interfaces may comprise charge carrier recombination, band bending, mechanical strains and metallic atoms diffusion through a semiconductor absorber.

A solar module according to the present disclosure avoids series resistance that may appear using a back transparent contact on a solar panel from few cm², for example, 3cm², to a full-size solar panel, wherein full-size may comprise dimensions such as 120cmx60cm or 1m².

A solar module according to the present disclosure may further comprise a buffer layer between the absorber layer and the front TCO layer. The buffer layer may allow improving the junction quality between the front TCO layer and the absorber layer. Such buffer layer may be of the order of a few tens of nanometers, nm. Both the front TCO layer and the buffer layer may have a same doping, so they are often conflated together as "window layer". The doping can be either "n", in which conduction may be performed by the electrons, or "p" in which conduction may be performed by holes. The buffer layer may have the opposite doping to a doping of the absorber, wherefrom the p-n or n-p junctions are performed. In thin film solar cells or solar modules, and especially for the commercial technologies, the absorber may be exclusively p-type, or with electric conduction from the holes. The buffer layer and the TCO may therefore be n-type, that is a conduction by the electrons. An n-type doping of the buffer layer may comprise, for example Cadmium sulfide, CdS, or zinc sulfide, ZnS, or Indium sulfide, In₂S₃. The TCO materials may be intrinsically n-doped, but an external doping may be used to increase their conductivity, which may remain 3 to 6 orders of magnitudes lower than that of a standard metal.

In other words, the absorber may be p-type, and the whole "window layer" may be n-type, creating a p-n junction, to separate the charge carriers, whereby holes are directed towards the rear TCM layer, and electrons are directed towards the front TCO layer.

A solar module according to the present disclosure may further comprise metallic fingers spaced from one another a distance between 100µm and 200 µm, although larger or shorter dimensions may be used.

A solar module according to the present disclosure may further comprise metallic fingers presenting a first dimension, for example a width, between 10 µm and 30 µm, although larger or shorter dimensions may be used. A solar module according to the present disclosure may further comprise metallic fingers presenting a second direction, for example a height, of 2 µm, although larger or shorter dimensions may be used.

A solar module according to the present disclosure may comprise metallic fingers spaced from one another a distance between 100µm and 200 µm, and which present a width between 10 µm and 30 µm, for example in a direction parallel or perpendicular to the flow of electrical current through the solar module or in any other direction. Such a solar module provides a shading of 10-30% or even 5% and eliminates issues related to series resistance. Such values provide a resolution of 300µm at 1m distance which is below the naked eye angular resolution at 1m distance, and the solar module may thus appear as homogeneously transparent to the naked eye.

The present disclosure presents, in a second aspect, a method for manufacturing a solar module according to the present disclosure. The method for manufacturing the solar module may comprise:
- providing a vacuum environment; the vacuum may be achieved inside a dedicated chamber which may be made of stainless steel. The vacuum may be created by a combination of pumps: a rotary pump where a so-called primary pumping may be performed, and a turbo molecular pump where a so-called secondary pumping, reaching a higher vacuum may be performed;
- providing a substrate in the vacuum environment, wherein the substrate may comprise a flat glass or be performed by a roll to roll process providing a flexible plastic, in which case, the plastic substrate may be transparent;
- sputtering at least a metallic finger in the vacuum environment; the sputtering may be performed on a side of the substrate, or on a side of a part of a rear TCM layer;
- sputtering a rear TCM layer on the side of the substrate in the vacuum environment;
- scribing the rear TCM layer through its entire thickness, or the complete rear TCM layer, stopping the scribing before reaching the substrate, in such a way that the substrate does not get scribed; scribing or patterning may be mechanical or laser scribing;
- depositing a photovoltaic absorber layer on the rear TCM layer;
- scribing the absorber layer through its entire thickness, stopping before reaching the rear TCM layer in such a way that the rear TCM layer does not get scribed under the same scribing that the scribing in the absorber layer;
- sputtering a front TCO layer on the absorber layer;
- scribing the front TCO layer, or the complete front TCO layer, or through its entire thickness, stopping before reaching the rear TCM layer.

The front contact is connected to the back contact of the next solar cell. At least one finger or a back or rear set of fingers forming a grid in contact to the rear TCM layer ensures the transport of the electric current over large areas, since series resistance of the rear TCM layer is bypassed or alleviated. Furthermore, the metallic grid of the present disclosure does not require a different machine to be used than what is being used for a standard back contact. Standard back contacts or rear layers, for example made of metallic molybdenum, Mo, may be fabricated by sputtering deposition in the vacuum environment. In the present disclosure, in the vacuum environment may be understood not breaking the vacuum environment provided which may be technically more efficient and which may save money. The back contact of the solar cell of the present disclosure may be fully made by sputtering deposition, using two targets, one for the metallic grid, and one for the rear TCM or TCO layer, instead of one target for the metallic Mo, wherein a target may be understood as a bulk material of a specific chemical composition from which particles are released upon a hit by high energy particles in the chamber; the released particles are deposited on a substrate, creating a thin film. For example, for Mo deposition, a plasma may be created at the vicinity of a Mo target, for example, a bulk molybdenum which may comprise about 1-2 Kg of pure Mo. Mo atoms are projected from the Mo target toward the substrate, and a thin Mo film may be fabricated on top of the substrate The cost of a method according to the present disclosure may therefore be minimal as compared to a cost for fabricating a standard monolithic solar module, and the total cost may be lower than the cost for manufacturing a standard planar design with a front metallic grid post-deposited by thermal evaporation.

Scribing may be mechanical or laser scribing. Mechanical scribing may be used for making integral interconnects in CIGSSe thin film solar modules and may be used to test some mechanical properties of an absorber film. Laser scribing is a technology which may be used for a cost-efficient industrial production of thin-film solar modules. Specific laser processes selectively remove layers between deposition processes, thereby creating monolithic cell-to-cell interconnections with a very small loss of productive area. Ultra-short pulsed lasers may be the tool of choice for scribing Cu(In,Ga)Se₂, CIGS, thin-film solar cells as they provide process selectivity and minimize thermal load on the surrounding material.

A method according to the present disclosure may comprise sputtering at least a metallic finger on a side of the substrate using a patterning mask. Using a patterning mask allows reproducing the same pattern when fabricating multiple solar cells in a safe and standardized fashion.

A method according to the present disclosure may comprise depositing an absorber layer, for example a photovoltaic absorber layer, by sputtering the absorber layer in the vacuum environment. Further sputtering the absorber layer allows uniformizing the fabrication process allowing thereby to reduce technical issues and lower the overall cost of manufacture.

A method according to the present disclosure may further comprise:
- depositing a buffer layer between the absorber and the front TCO layer and
- laser scribing from the buffer layer stopping before reaching the rear TCM layer.

A method according to the present disclosure may further comprise depositing a photovoltaic absorber by combining sputtering and thermal annealing. If the sputtered absorber is not crystallized, then annealing may bring the material at a temperature and pressure conditions exceeding the formation energy of the compound, allowing thereby a complete crystallization of the material. For example, a chalcogen element, for example Se, or S, or Te, may be provided during the annealing process for bringing the absorber to its stoichiometric composition rather than during the sputtering step. For example, the so-called method "reactive sputtering" comprises both crystallization conditions and a chalcogen element, thus allowing to fabricate the absorber in a single sputtering step. An example method may comprise deposition of a non-crystallized metallic precursor, for example, Cu, or In, or Ga and annealing while providing a chalcogen element, for example Se, or S or Te to achieve a desired chemical composition and complete crystallization of the absorber.

The solar module and the method according to the present disclosure allow improving the current solar module designs and provide for a bifacial light harvesting which increases the overall efficiency of a solar module.

### Brief Description of the Drawings

Understanding that these drawings depict only example embodiments of the disclosure and are not therefore to be considered to be limiting of its scope, the principles herein are described and explained with additional specificity and detail through the use of the accompanying drawings in which:
FIG. 1 represents an example of a solar module according to the invention.
FIG. 2 represents an example of a solar module according to the invention.
FIG. 3 represents an example of a solar module according to the invention.
FIG. 4 represents an example of a solar module according to the invention.
FIG. 5 represents an example of a solar module according to the invention.
FIG. 6 represents an example of a fabrication process of a solar module according to the invention.
FIG. 7 represents an example of an electrical current flowing through a solar module according to the invention.
FIG 8. represents an example of a view of a solar module according to the invention.
FIG 9. represents an example of a view of a solar module according to the invention.

### Detailed Description

The following description and drawings are illustrative and are not to be construed as limiting. Numerous specific details are described to provide a thorough understanding of the disclosure. In certain instances, however, well-known or conventional details are not described in order to avoid obscuring the description. References to one or an example in the present disclosure can be, but not necessarily are, references to the same example; and, such references mean at least one of the examples.

Reference to "one example" or "an example" means that a particular feature, structure, or characteristic described in connection with the example is included in at least one example of the disclosure. The appearances of the phrase "in one example" in various places in the specification are not necessarily all referring to the same example, nor are separate or alternative examples mutually exclusive of other example. Moreover, various features are described which may be exhibited by some examples and not by others. Similarly, various features are described which may be features for some examples but no other examples.

The terms used in this specification generally have their ordinary meanings in the art, within the context of the disclosure, and in the specific context where each term is used. Alternative language and synonyms may be used for any one or more of the terms discussed herein, and no special significance should be placed upon whether or not a term is elaborated or discussed herein. Synonyms for certain terms are provided. A recital of one or more synonyms does not exclude the use of other synonyms. The use of examples anywhere in this specification including examples of any terms discussed herein is illustrative only and is not intended to further limit the scope and meaning of the disclosure or of any exemplified term. Likewise, the disclosure is not limited to various examples given in this specification.

Additional features and advantages of the disclosure will be set forth in the description which follows, and in part will be obvious from the description, or can be learned by practice of the herein disclosed principles. The features and advantages of the disclosure can be realized and obtained by means of the instruments and combinations particularly pointed out in the appended claims. These and other features of the disclosure will become more fully apparent from the following description and appended claims or can be learned by the practice of the principles set forth herein.

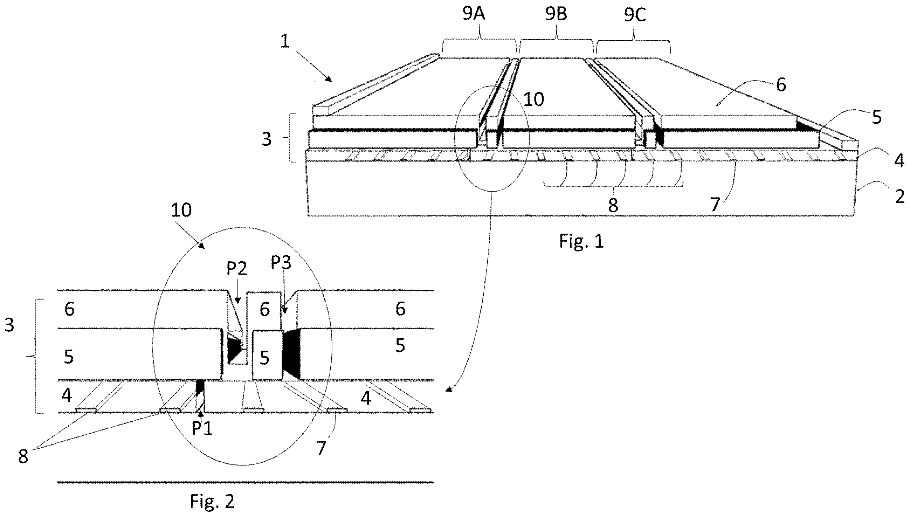

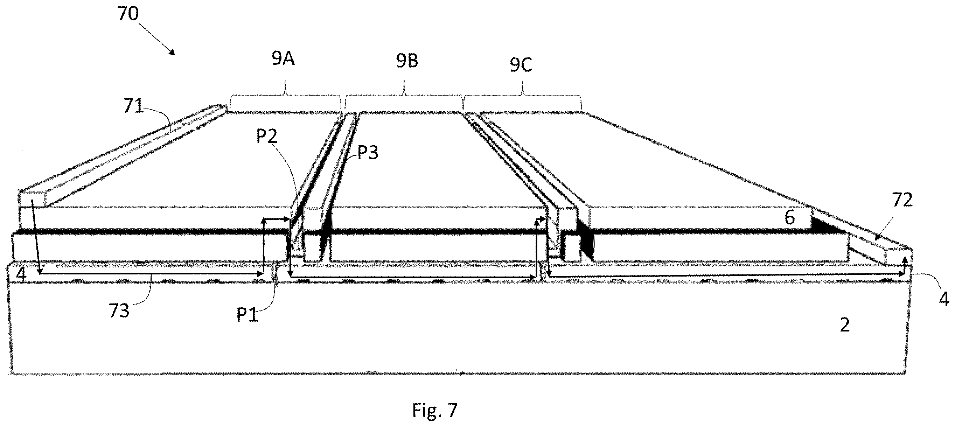

Example methods of the present disclosure may comprise a solar module schematically shown in figure 1 and in figure 2. Figure 1 represents an example of a solar module (1), comprising:
- a substrate (2), which may be made of clean soda lime glass, and
- a layered structure (3) contacting the substrate (2), the layered structure (3) comprising:
   - a rear transparent conductive material, TCM, layer (4), in contact with the substrate (2);
   - an absorber layer (5) in contact with the rear TCM layer (4);
   - a front transparent conducting oxide, TCO, layer (6) in contact with the absorber layer (5) in such a way that the absorber layer (5) remains between the front TCO layer (6) and the rear TCM layer (4);
- the layered structure of figure 1 comprises, as shown in an augmented area (10) in figure 2, two electrically insulating zones, (P1, P3) configured for redirecting an electrical current flowing through a layer or in other words, the electrically insulating zones, in operation, stop an electric current from flowing at the electrically insulating zones (P1, P3) through the same layer, as shown in figure 7;
- a solar cell is a structure delimited by two pairs of electrically insulating zones (P1, P3),
- the layered structure of figure 2 comprises a connection zone (P2) in such a way that, when serially connecting a set of solar cells (9), the front TCO layer (6) of a first solar cell (9A) contacts the rear TCM layer (4) of a second solar cell (9B) and the front TCO layer (6) of the second solar cell (9B) contacts the rear TCM layer (4) of a third solar cell (9C);and
- the rear TCM layer (4) further contacts at least a part of a metallic finger (7), wherein the metallic finger is configured to provide at least a conduction channel across the rear TCM layer.

The transparent zones of figure 2 correspond to the layers as follows: P1 stops the current flowing within rear TCM layer (4), and P3 stops the current flowing within front TCO layer (6).

The connection zone P2 allows a connection between the front TCO layer (6) of a given stripe and the rear TCM layer (4) of an adjacent solar cell.

Figures 1 and 2 show an example of metallic finger (7) comprising a rectangular-shaped cross section, but other shapes may also be possible, for example, T-shaped cross section, or triangular-shaped cross section, or circular-shaped cross section or elliptical-shaped cross section or square-shaped cross section or sliver-shaped cross section, and any other. Figures 1 and 2 show an example of a metallic grid (8) wherein the metallic fingers (7) are parallel with each other. A skilled person in the art may understand that any sort of pattern may be used and optimized depending on the needs.

As seen in figures 1 and 2, the metallic fingers of the example may form a metallic grid (8), wherein the metallic grid may be placed at the substrate-rear TCM layer (4) interface. For example, a method for the fabrication of such example solar module of figures 1 and 2 may comprise providing a substrate (2) in a vacuum environment, subsequently sputtering the metallic grid (8) using, or with the help of, a patterning mask in the vacuum environment and subsequently sputtering the rear TCM layer (4) on a side of the substrate (2) in the vacuum environment in such a way that a side of the metallic fingers (7) are in contact with the substrate (2) and the sputtering covers 3 parts of each metallic finger (7) of the metallic grid (8).

Benefits in terms of conduction may scale with a size of a solar panel or module, where the solar panel may comprise a solar cell or a set of solar cells. The larger the size of the module, the more beneficial a metallic grid may become. A rear TCM layer series resistance may be reduced by a factor of 12 in a 3cm² solar cell when using a molybdenum, Mo, grid with a film thickness of 400nm and a coverage area of 20%. When comparing the conduction of a TCM or TCO layer on a given distance, for example about 1 meter, with the conduction given by metallic fingers on the same distance, the metallic fingers may provide a factor of at least 100 in conduction.

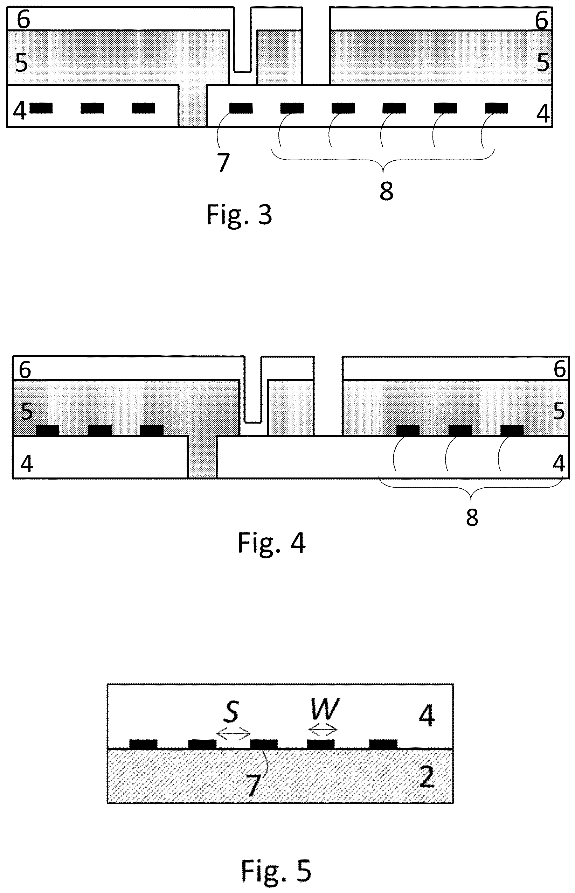

Figure 3 and figure 4 represent respective cross section views of alternative designs with a metallic collection grid embedded in the rear TCM layer (4) in Fig. 3, and at the rear TCM layer (4)/absorber (5)-interface, in Fig. 4.

For fabricating the solar module of figure 3 an example method of fabrication may comprise sputtering at least a metallic finger (7) in the vacuum environment before sputtering the rear TCM layer (4) on a side of the substrate (2) in the vacuum environment, whereby a part of the metallic grid (8) contacts the substrate (2). In particular, the method may comprise depositing part of the rear TCM layer (4) on a glass substrate (not shown), depositing a metallic grid (8) on such part of the rear TCM layer (4) and subsequently depositing the rest of the rear TCM layer (4) on top of the metallic grid, wherein depositing may comprise sputtering in a vacuum environment.

For fabricating the solar module of figure 4, an example method of fabrication may comprise sputtering a rear TCM layer (4) on a side of the substrate (2) in the vacuum environment before sputtering at least a metallic finger (7) or a metallic grid (8) in the vacuum environment on top of the rear TCM layer (4), and further depositing or sputtering a rest of a rear TCM layer (4) on top of the metallic grid, in such a way that the metallic finger (7) or the metallic grid (8) gets surrounded by the TCM layer (4). In particular, the method may comprise fully depositing a rear TCM layer (4) on top of a glass substrate (not shown) and subsequently depositing of a metallic grid (8) on top of the rear TCM layer (4).

In the examples shown in figures 1, 2, 3, 4, the current generated in the absorber (5) is collected at the front TCO layer (6) and rear TCM layer (4) of the solar module. The monolithic designs shown in the figures provide that the front TCO layer (6) is interconnected in series with the rear TCM layer (4) of a nearby solar cell. The rear TCM layer (4) transfers charge carriers to the metallic grid (8) to minimize the losses from series resistance for a large area solar module. The shading from the metallic collection grid may be tuned by adjusting the width of the metallic fingers (7) and the spacing between them. Hence, a user may be able to balance a trade-off between rear TCM layer transparency and collection efficiency. A shading from 10 to 30% may be enough to fully eliminate issues relating to series resistance. An improved visual aspect can be obtained by using micrometric metallic grid, with fingers of the order of 10-30µm in width and a spacing between them of the order of 100-200µm; those values are below the naked eye angular resolution at 1m distance, which is 300µm at 1m distance, and the contact may thus appear as homogeneously transparent to the naked eye.

Such naked-eye concept may be used for semi-transparent glass with a tuneable conduction and transparency, as illustrated figure 5. Fig. 5 represents an example of solar cell where the spacing, *S*, and the width, W, are chosen below the angular resolution of the naked eye at the desired viewing distance. The calculation of the transparency and conduction of the resulting semi-transparent glass may be evaluated as follows: the transparency is in direct relation to the surface area covered by the metallic grid. If the grid covers, for example 20% of the surface, the transparency is 80%, The conductivity depends on the resistivity of the metal used, wherein the general formula is the one of the resistance of a metallic wire R=ρL/A, being R the resistance of the wire, i.e. metallic finger of figures 1 and 2; being p the resistivity of the metal used for the fingers, L the length of the wire, and A the cross sectional area of the wire. This formula may vary depending on the design of the solar panel. For example, the conduction may be adapted depending on the current density which is desired and which resistance is deemed acceptable. A current density value of thin film solar modules may be 30mA.cm⁻². A sweet spot maximizing the efficiency between the transparency of the back contact and the conductivity of the back contact may be found.

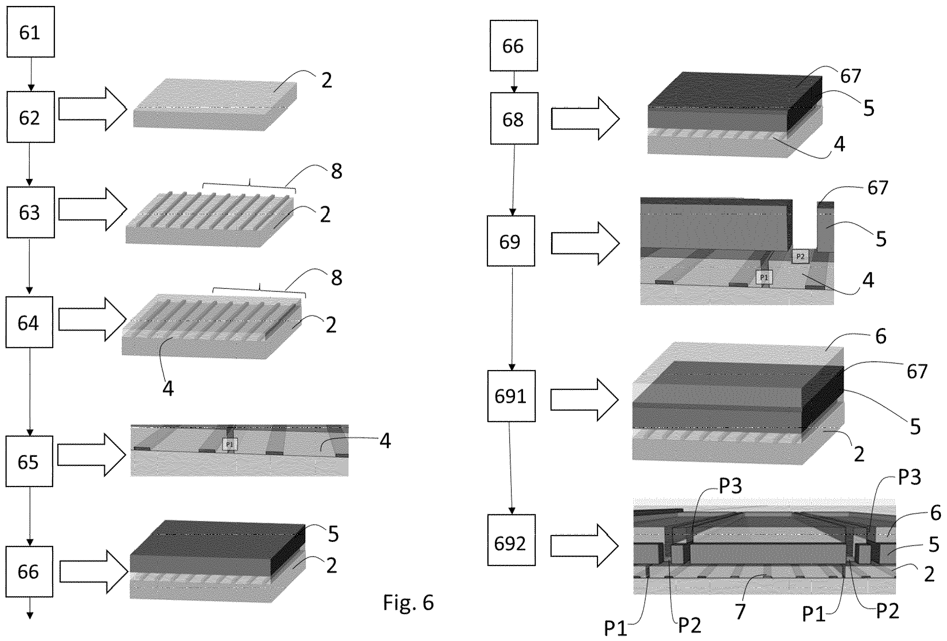

Figure 6 shows an example of a method for fabricating a solar module according to the present disclosure. Figure 6 shows the following steps:
- providing a vacuum environment (61);
- providing a substrate (2) in the vacuum environment (62);
- sputtering at least a metallic finger (7) in the vacuum environment (63); the sputtering of the metallic finger may comprise the use of a patterning mask; such patterning mask may define the width of the metallic and spacing between metallic fingers in the case where several metallic fingers, forming for example a metallic grid, are deposited or sputtered;
- sputtering a rear TCM layer (4) on a side of the substrate (2) in the vacuum environment (64);
- scribing (P1) the complete rear TCM layer (4) (65) stopping before reaching the substrate (2);
- depositing an absorber layer (5) (66); which may comprise sputtering in the vacuum environment;
- depositing (68) a buffer layer (67);
- laser or mechanical scribing (69) (P2) from the buffer layer (66) stopping before reaching the rear TCM layer (4);
- sputtering a front TCO layer (6) (691);
- laser or mechanical scribing (692) (P3) the complete front TCO layer (6) stopping before reaching the rear TCM layer (4).

The method of the present disclosure advantageously offers the possibility of using a same sputtering chamber for depositing the metallic grid and the rear TCM layer consecutively. A patterning mask for building the metallic grid may be put in place and then removed using, for example, a robotic arm within the chamber.

Regarding the function of the transparent zones P1, P3 and the connection zone, P2. The scribing separates the solar cells or solar stripes, except for P2 which connects cells in series. The area between P1 and P3 may be called a "dead zone", as such area does not contribute to a photovoltaic current. P2 conforms the junction between 2 consecutive cells or stripes, in series.

P1 is scribed after the deposition of the rear TCM (4) layer, which in figure 5 comprises metallic grid or fingers and a transparent conductive material, e.g. a TCO. P1 disconnects therefore solar cells of the back contact among each other.

P2 is scribed after the deposition of the buffer layer, and it scribes the buffer (67) and the absorber (5), but not the rear TCM layer (4). When deposing the front TCO layer (6) at the following step (691), the front TCO layer (6) connects with the rear TCM layer (4) at P2. Since P1 disconnected stripes of the back contact, there is no short circuit within the same solar cell.

P3 is scribed after the deposition of the front TCO layer (6), and the buffer layer (67) and the absorber (5) are also scribed, but not the rear TCM layer (4); P3 disconnects the front TCO contact (6) of different solar cells. As seen in the finished step 692 of figure 5, the left border of a n-th solar cell is defined by the scribing P3 of the n-1 solar cell. The right border of the n-th solar cell is defined by the scribing P1 of the n-th solar cell, and so on for the rest of solar cells constituting a complete module. The area between P1 and P3 does not produce any current and may be called a "dead zone". The size of the dead zone may be less than 10% of the total area of the solar panel.

The combination of the different solar cells or stripes in series forms a solar module, monolithically interconnected. A solar module may be composed of a very large number of solar cells, for example, from 10 or 20 or 50 up to 100, or 200.

Thin film solar modules with transparent back contacts at a small scale, where series resistance effects are not significantly detrimental to the performance of the device have been developed. Advantages may be obtained by the implementation of a fabrication method and a solar module according to the present disclosure, such as the fabrication of a transparent contact with tunable transparency and improved conduction thanks to the metallic finger or metallic grid as compared to the commonly used bifacial thin film solar cells. Besides, a solar module according to the present disclosure alleviates some issues related to the series resistance at the back contact when using a standard TCM or TCO, while keeping the standard industrial monolithic integration of solar cells and/or invariable. A solar module according to the present disclosure may further render the metallic fingers invisible to the naked eye by using a micrometric patterning, below the eye resolution.

Figure 7 represents an example of an electrical current flowing through a solar module according to the invention. As seen in figure 7, the layered structure (3) comprises at least an electrically insulating zone configured for redirecting an electrical current flowing through a layer, such that, in operation, electric current stops flowing at a same layer at the electrically insulating zone; in other words, each insulating zone avoids, at each layer, current from continuing flowing through a same layer. Such configuration obliges a current to find an alternative electrical pathway through other layers. For example, if a positive pole (71) or positive contact is placed at a side of a solar module (70) and a negative pole (72) or negative contact is placed at an opposite side of a solar module, a current (74) may be generated from the positive contact (71), in contact with a solar cell (9A) towards the negative contact (72) in contact with a third cell (9B). The current (74) may flow through the rear TCM layer (4) until an insulating zone (P1) in the rear TCM layer (4), where the electrical current (73) may find an alternative pathway through the absorber layer (5) and through the front TCO layer (6). Flowing through the front TCO layer (6), the electrical current (73) may find an insulting zone (P3) in the front TCO layer, where the electrical current (73) may find an alternative pathway through the absorber layer (5), through a contacting zone (P2) and through a rear TCM layer (4) of a following solar cell (9B). The insulating or electrical transparent zones allow avoiding short circuits and disconnecting some layers from others. The current flow in the rear TCM layer (4) is enhanced by the presence of metallic fingers (7) acting as electric conduction channels.

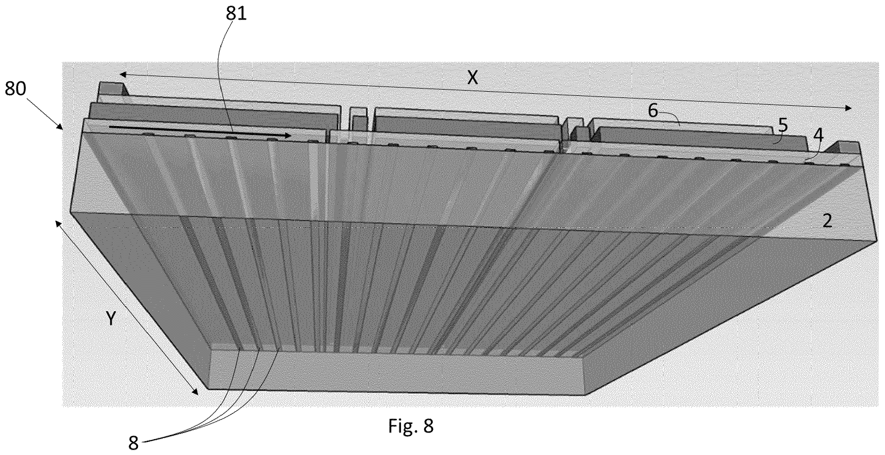

Figure 8 represents an example of a bottom view of a solar module (80) according to the invention. As seen in figure 8, the set of metallic fingers (8) or grid may extend over a part of the solar module (80) or may cover a whole dimension (Y) of the solar module, perpendicularly to a direction (X) in which an electrical current (81) may flow. The metallic fingers (8) do not contact each other between different stripes, and a metallic finger (8) is not continuous between different stripes.

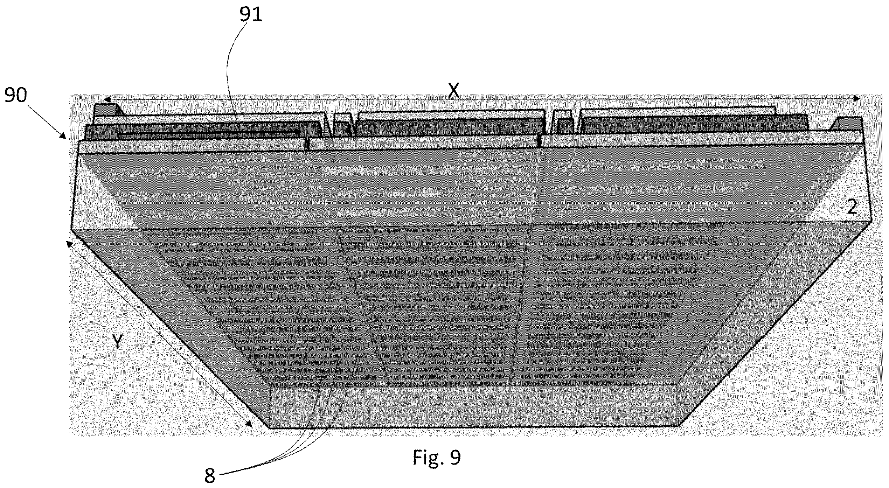

Figure 9 represents an example of a bottom view of a solar module (90) according to the invention. As seen in figure 9, the set of metallic fingers (9) or grid may cover a whole dimension (X) of each solar cell, parallel to a direction (X) in which an electrical current (91) may flow across a layer. The metallic fingers (8) do not contact each other between different stripes, and a metallic finger (8) is not continuous between different stripes.

In the scope of industrial solar modules or panels, comprising a set of solar cells, a solution has been found in the present disclosure regarding the series resistance issue resulting from the replacement of the back metallic contact by a lower conductivity material. The present disclosure provides for a monolithic interconnection of solar cells into modules and compatible with current industrial processes, while offering a simple tuning of the transparency/conduction trade-off. A solar module according to the present disclosure provides for a transparent conductive glass with a metallic grid patterning, possibly below the naked eye resolution at the desired viewing distance. Possible applications might be photovoltaic applications or electrochromic windows.

In other words, some of the advantages provided by the present disclosure may be:
- Compatibility: very minor alteration of the method for manufacturing a solar module compared to the existing ones; the current production lines may be adapted for a minimal cost;
- Resilience: close to no loss in efficiency for a standard front side only illumination;
- Increased output: bifacial property for the panel, receiving light from the front side and the back side, hence significantly increasing the power output of the panel;
- Adaptability: full tunability of the trade-off between back side transparency and electric conduction; depending on the desired properties, the width and spacing of the metallic fingers may be adapted by the maker with a simple change of mask;
- Building Integrated Photovoltaics, BIPV: feasibility of near invisible contacts using ultrathin metallic fingers of a few µm of width and spacing.
- A future proofed idea: direct application possible in semi-transparent inorganic thin film solar modules and fully transparent solar modules, transparent back contacts such as those proposed here are fully adaptable to the need of solar windows. Direct application to the back contact for a top cell in tandem photovoltaic module designs is also foreseeable.

## Claims

1. A solar module (1) comprising a plurality of solar cells connected in series, the solar module comprising:
- a substrate (2) and
- a layered structure (3) contacting the substrate (2), the layered structure (3) comprising:
- a rear transparent conductive material, TCM, layer (4), in contact with the substrate (2);
- an absorber layer (5) in contact with the rear TCM layer (4);
- a front transparent conducting oxide, TCO, layer (6) in contact with the absorber layer (5) the absorber layer (5) being between the front TCO layer (6) and the rear TCM layer (4);
- at least two electrically insulating zones (P1, P3), configured for redirecting an electrical current flowing through a layer,
- a solar cell being delimited between 2 pairs of electrically insulating zones (P1, P3),
- at least a connection zone (P2) such that a front TCO layer (6) of a first solar cell (9A) contacts a rear TCM layer (4) of a second solar cell (9B) and a front TCO layer (6) of the second solar cell (9B) contacts a rear TCM layer (4) of a third solar cell (9C); and
- wherein the rear TCM layer (4) further contacts at least a first part of a metallic finger (7) configured to provide at least a conduction channel for the electrical current to flow across the rear TCM layer.

2. A solar module according to claim 1 wherein the substrate (2) contacts at least a second part of the metallic finger (7).

3. A solar module according to any of the preceding claims further comprising a set of metallic fingers (7) forming a metallic grid (8).

4. A solar module according to claim 3 wherein the metallic fingers (7) are spaced from one another a distance (d) between 100µm and 200 µm.

5. A solar module according to claim 3 or 4 wherein the metallic fingers (7) present a width (w) between 10 µm and 30 µm.

6. A solar module according to any one of the preceding claims further comprising a buffer layer between the absorber layer (5) and the front TCO layer (6).

7. A solar module according to any one of the preceding claims wherein the TCM layer (4) comprises a transparent conducting oxide, TCO, layer.

8. A solar module according to any one of the preceding claims wherein the TCO layers comprise indium tin oxide, ITO, fluorine doped tin oxide, FTO.

9. A method for manufacturing a solar module (1) according to one of claims 1 to 8, comprising:
- providing a vacuum environment;
- providing a substrate (2) in the vacuum environment;
- sputtering at least a metallic finger (7) in the vacuum environment;
- sputtering a rear TCM layer (4) on a side of the substrate (2) in the vacuum environment;
- scribing (P1) the rear TCM layer (4), stopping before reaching the substrate (2)
- depositing an absorber layer (5);
- scribing (P2) the absorber layer (5), stopping before reaching the rear TCM layer (4);
- sputtering a front TCO layer (6) on the absorber layer (5);
- scribing (P3) the front TCO layer (6), stopping before reaching the rear TCM layer (4).

10. A method according to claim 9 wherein sputtering at least a metallic finger (7) in the vacuum environment is performed on the side of the substrate before sputtering the rear TCM layer (4) on the side of the substrate (2) in the vacuum environment, wherein a part of the at least one metallic finger (7) contacts the substrate (2).

11. A method according to claim 9 wherein sputtering a rear TCM layer (4) on a side of the substrate (2) in the vacuum environment is performed before sputtering at least a metallic finger (7) in the vacuum environment on the rear TCM layer (4).

12. A method according to claim 11 further comprising, subsequently to sputtering at least a metallic finger (7) in the vacuum environment on the rear TCM layer (4), depositing or sputtering a rest of a rear TCM layer (4) on the at least one metallic finger (7).

13. A method according to any one of claims 9 to 12 wherein sputtering at least a metallic finger (7) on a side of the substrate (2) comprises using a patterning mask.

14. A method according to any one of claims 9 to 13 wherein depositing an absorber layer (5) comprises sputtering the absorber layer in the vacuum environment.

15. A method according to any one of claims 9 to 14 further comprising:
- depositing a buffer layer between the absorber and the front TCO layer (6), and
- scribing (P3) the buffer layer stopping before reaching the rear TCM layer (4).
